# EUROPÄISCHE PATENTANMELDUNG

(11) **EP 2 285 000 A2**
(43) Veröffentlichungstag der Anmeldung: **16.02.2011**
(21) Anmeldenummer: 10171243.8
(22) Anmeldetag: 29.07.2010
(51) Int. Cl.: H03K 17/97, F24C 7/08

(54) **Bedienvorrichtung für ein Elektrogerät**

(30) Priorität: 10.08.2009 DE 102009037825
(71) Anmelder: E.G.O. Elektro-Gerätebau GmbH, 75038 Oberderdingen (DE)
(72) Erfinder: Baier, Martin, 76275, Ettlingen (DE)
(74) Vertreter: Baumann, Jörg

(57) **Zusammenfassung**

Eine Bedienvorrichtung für ein Elektrogerät weist als Bedieneinheit einen Drehknebel auf, der elektrische Anzeigemittel aufweist. Der Drehknebel ist auf eine Drehachse aufgesetzt, die mit einem Schaltgerät verbunden ist zur Drehbedienung, wobei die Drehachse aus einem Material besteht, das die magnetischen Feldlinien gut leitet. Es ist eine induktive Energieversorgung für die Anzeigemittel vorgesehen, wobei in dem Drehknebel eine Sekundärwicklung angeordnet ist, deren Wicklungsebene von der Drehachse und den magnetischen Feldlinien einer Primärwicklung durchdrungen ist. Die Primärwicklung ist hinter der Abdeckung des Elektrogeräts angeordnet und eine Wicklungsebene der Primärwicklung ist von der Drehachse durchdrungen.

## Beschreibung

### Anwendungsgebiet und Stand der Technik

Die Erfindung betrifft eine Bedienvorrichtung für ein Elektrogerät mit einer Bedieneinheit, die als Drehknebel ausgebildet ist.

Aus der DE 10212954 A1 ist es bekannt, eine als Drehknebel ausgebildete Bedieneinheit durch eine Abdeckung des Elektrogeräts hindurch induktiv mit Energie zu versorgen. Durch die geschlossene Abdeckung hindurch sind eine Primärwicklung unter der Abdeckung und eine Sekundärwicklung in der Bedieneinheit völlig voneinander getrennt. Die Energieübertragung ist nicht besonders effizient.

### Aufgabe und Lösung

Der Erfindung liegt die Aufgabe zugrunde, eine eingangs genannte Bedienvorrichtung zu schaffen, mit der Probleme des Standes der Technik beseitigt werden können und insbesondere eine vorteilhafte Ausbildung der Bedienvorrichtung erreicht wird mit einfacher und vorteilhafter sowie effizienter Energieübertragung.

Gelöst wird diese Aufgabe durch eine Bedienvorrichtung mit den Merkmalen des Anspruchs 1. Vorteilhafte sowie bevorzugte Ausgestaltungen der Erfindung sind Gegenstand der weiteren Ansprüche und werden im Folgenden näher erläutert. Der Wortlaut der Ansprüche wird durch ausdrückliche Bezugnahme zum Inhalt der Beschreibung gemacht.

Es ist vorgesehen, dass die Drehachse mit einem Schaltgerät verbunden ist zur Drehbedienung mittels des Drehknebels. In dem Drehknebel sind dabei elektrische Anzeigemittel angeordnet, die beispielsweise zur Informationsdarstellung an eine Bedienperson dienen können. Erfindungsgemäß ist eine induktive Energieversorgung der Anzeigemittel vorgesehen, wobei in dem Drehknebel eine Sekundärwicklung angeordnet ist und unterhalb der Abdeckung eine Primärwicklung angeordnet ist, die von der Drehachse durchdrungen wird, wobei die Drehachse aus einem Material besteht, das die magnetischen Feldlinien gut leitet. Die Wicklungsebene der Sekundärwicklung wird von der Drehachse und somit von den magnetischen Feldlinien der Primärwicklung durchdrungen. So ist es möglich, dass eine Strecke bzw. der Übertragungsweg zwischen den von der Primärwicklung ausgehenden magnetischen Feldlinien und der Sekundärwicklung in der Bedieneinheit sehr gering ist. Insbesondere dadurch, dass die magnetischen Feldlinien der Primärwicklung von der Drehachse sozusagen übertragen werden und diese Drehachse die Ebene der Sekundärwicklung durchdringt, ist der Wirkungsgrad der induktiven Energieübertragung besonders gut. Dadurch werden vor allem auch sozusagen magnetische Streuverluste verringert, die umgebende elektrische Geräte oder Einrichtungen stören könnten.

In Weiterbildung der Erfindung kann sogar vorgesehen sein, dass die Primärwicklung selbst die Ebene der Sekundärwicklung durchdringt. Dazu kann sie an oder in der Drehachse für den Drehknebel verlaufen, beispielsweise, wenn diese Drehachse eine Hohlachse ist. Auch hier kann die Drehachse dazu dienen, die Feldlinien zu bündeln bzw. in gewünschtem Maß zu leiten. Zusätzlich dient sie dann zur Halterung der Primärwicklung.

Alternativ dazu und besonders vorteilhaft kann die Primärwicklung an oder in dem Schaltgerät angeordnet sein, beispielsweise in einem Schaltgerätgehäuse. Sie kann eine Wicklungsebene aufweisen, die im Wesentlichen senkrecht zu der Drehachse ist, wobei sie auch von der Drehachse durchdrungen wird, und somit wiederum in etwa parallel zur Sekundärwicklung in der Bedieneinheit ist.

Um die Sekundärwicklung in dem Drehknebel anzuordnen, kann sie entweder als separates Bauteil darin eingelegt sein. Alternativ kann sie eingespritzt sein. Dabei ist es in weiterer Ausgestaltung der Erfindung auch möglich, die Sekundärwicklung als Modul auszubilden, beispielsweise in einem Wicklungsgehäuse oder als umspritztes Bauteil. So kann sie dann in einer entsprechend ausgebildeten Aussparung im Drehknebel befestigt werden, beispielsweise durch Einrasten oder Verkleben. So ist eine genaue Lage und feste Anordnung möglich.

Die Anzeigemittel in dem Drehknebel sind vorteilhaft als LED ausgebildet, beispielsweise auch OLED. Sie können einzelne Lichtpunkte darstellen, alternativ ganze Flächen beleuchten oder auch Sieben-Segment-Anzeigen odgl. bilden. Es können auch Glimmlampen verwendet werden.

In weiterer Ausgestaltung der Erfindung ist eine Gleichrichtung an der Sekundärwicklung im Drehknebel angeschlossen. Hier bietet sich ein Brückengleichrichter an, der zum Betrieb der vorgenannten LED als Anzeigemittel geeignet ist.

Ähnlich wie zuvor nur für die Sekundärwicklung beschrieben, können sämtliche weiteren Bauteile in dem Drehknebel befestigt werden durch Vergießen bzw. Ein- oder Umspritzen. Alternativ dazu können auch noch weitere Teile in dem Drehknebel, beispielsweise für die Energieversorgung, für die Anzeigemittel wie die vorgenannte Gleichrichtung oder auch die Anzeigemittel selbst als Modul ausgebildet sein. Auch sie können, wie für die Sekundärwicklung vorbeschrieben, in entsprechend ausgebildeten Aussparungen in dem Drehknebel befestigt werden. Durch einen derartigen modulartigen Aufbau ist es möglich, eine erfindungsgemäße Bedienvorrichtung bzw. vor allem den Drehknebel je nach gewünschtem Funktionsumfang mit unterschiedlichen Funktionalitäten auszurüsten. So können beispielsweise unterschiedlich ausgestattete Ausstattungsvarianten geschaffen werden bei einem gleichzeitig grundsätzlichen Aufbau des Drehknebels bzw. auch der Energieübertragung.

In ähnlicher Weise können auch die Teile der Energieversorgung für die Anzeigemittel, die die Primärwicklung enthalten und unter der Abdeckung angeordnet sind, als Modul ausgebildet sein. Eins solches Modul kann dann an dem Schaltgerät befestigt werden, beispielsweise als an sich bekanntes Aufsatzteil.

Diese und weitere Merkmale gehen außer aus den Ansprüchen auch aus der Beschreibung und den Zeichnungen hervor, wobei die einzelnen Merkmale jeweils für sich allein oder zu mehreren in Form von Unterkombinationen bei einer Ausführungsform der Erfindung und auf anderen Gebieten verwirklicht sein und vorteilhafte sowie für sich schutzfähige Ausführungen darstellen können, für die hier Schutz beansprucht wird. Die Unterteilung der Anmeldung in einzelne Abschnitte sowie Zwischen-Überschriften beschränken die unter diesen gemachten Aussagen nicht in ihrer Allgemeingültigkeit.

### Kurzbeschreibung der Zeichnungen

Ausführungsbeispiele der Erfindung sind in den Zeichnungen schematisch dargestellt und werden im Folgenden näher erläutert. In den Zeichnungen zeigen:
- Fig. 1: eine seitliche Schnittdarstellung durch eine erfindungsgemäße Bedienvorrichtung mit magnetisch leitender Drehachse, die eine Primärwicklung in einem Schaltgerät und eine Sekundärwicklung in einem Drehknebel magnetisch koppelt zur Energieversorgung einer Anzeige im Drehknebel,
- Fig. 2: eine Abwandlung des Drehknebels aus Fig. 1 mit einem teilwei- se modulartigen Aufbau und
- Fig. 3: eine weitere Abwandlung mit einem anders ausgebildeten mo- dulartigen Aufbau.

### Detaillierte Beschreibung der Ausführungsbeispiele

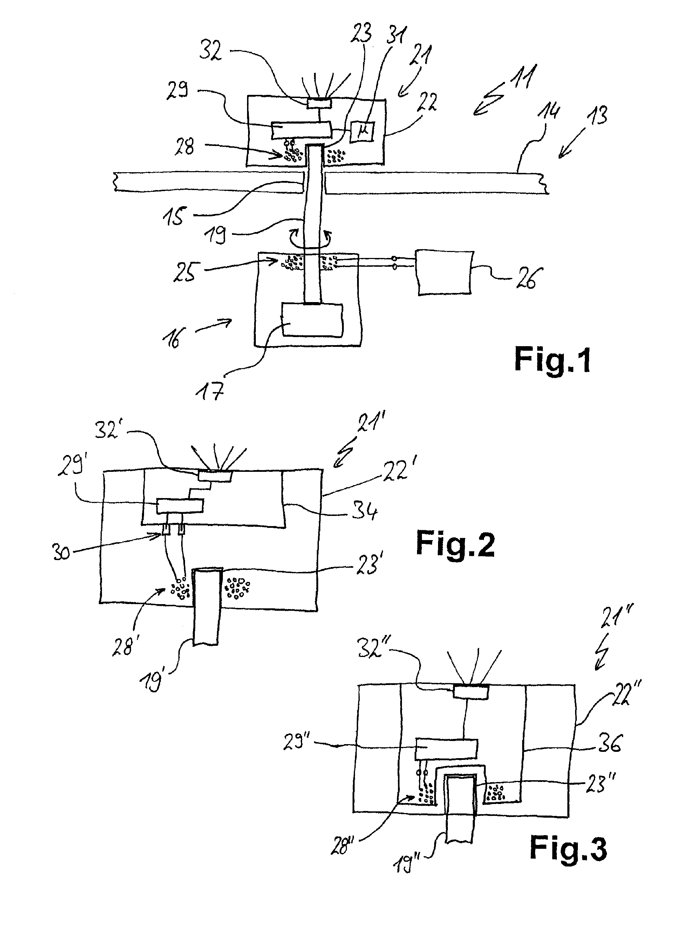

In Fig. 1 ist in einer schematischen Schnittdarstellung eine erfindungsgemäße Bedienvorrichtung 11 gezeigt an einem Elektrogerät 13 mit einer Abdeckung 14, welche auch eine sogenannte Blende sein kann. In der Abdeckung 14 befindet sich ein Durchbruch 15.

Unter der Abdeckung 14 ist ein Schaltgerät 16 angeordnet, welches einen Drehschalter 17 aufweist. Dieser kann beispielsweise zur Leistungseinstellung einer elektrischen Funktionseinheit des Elektrogeräts 13 dienen, beispielsweise einer Strahlungsheizung im Fall eines Glaskeramik-Kochfeldes. Der Drehschalter 17 in dem Schaltgerät 16 wird über eine Drehachse 19 betätigt, welche durch den Durchbruch 15 bis vor die Abdeckung 14 reicht. Dort ist die Drehachse 19 in einen Drehknebel 21 als eingangs genannte Bedieneinheit der Bedienvorrichtung 11 eingesteckt und befestigt. Der Drehknebel 21 weist ein Drehknebelgehäuse 22 auf, welches an der Unterseite eben eine Drehachsenaufnahme 23 aufweist zum Einstecken bzw. Befestigen der Drehachse 19. So kann mittels des Drehknebels 21 eine Einstellung am Drehschalter 17 vorgenommen werden. Dies ist aus dem Stand der Technik bekannt.

In dem Schaltgerät 16 befindet sich im oberen Bereich eine Primärwicklung 25, die aus einer mehrwindigen Spule besteht, beispielsweise aus dünnem isolierten Kupferdraht mit 10 bis 100 Windungen. Sie kann auf an sich bekannte Art und Weise ausgebildet und in einem Gehäuse des Schaltgeräts 16 befestigt sein. Die Primärwicklung 25 ist mit einer Ansteuerung 26 verbunden, auf die nachstehend noch genauer eingegangen wird. Die magnetischen Feldlinien der Primärwicklung 25 werden von der Drehachse 19 weitergeleitet, die erfindungsgemäß aus einem Material besteht, das magnetische Feldlinien gut leitet. Eine solche Drehachse 19 kann ferritisch sein, alternativ aus einem entsprechenden Eisen bzw. verschiedenen Eisenlegierungen mit den gewünschten Eigenschaften bestehen. Des weiteren sind allgemein Kunststoffe mit eingelagerten magnetischen bzw. ferritischen Partikeln möglich, beispielsweise Eisenspänen oder Ferritstaub. So kann erreicht werden, dass die Drehachse elektrisch nicht leitend ist. Dies ist dem Fachmann bekannt und stellt ihn vor keinerlei Probleme.

Das obere Ende der Drehachse 19 durchdringt eine Wicklungsebene einer im unteren Bereich des Drehknebels 21 vorgesehenen Sekundärwicklung 28. Die Sekundärwicklung 28 kann grundsätzlich ähnlich ausgebildet sein wie die Primärwicklung 25 und eine zur Anwendung passende Anzahl von Windungen aufweisen, beispielsweise auch 10 bis 100.

Es ist also zu erkennen, dass die magnetisch gut leitende Drehachse 19 die Primärwicklung 25 mit der Sekundärwicklung 28 magnetisch koppelt und somit eine Art Transformator mit den beiden Wicklungen 25 und 28 sowie einem Kern 19 entsteht. Die Sekundärwicklung 28 ist mit einem Gleichrichter 29 im Drehknebel 21 verbunden, der die transformatorisch bzw. induktiv übertragene Energie in geeigneter Form nutzbar macht. So kann der Gleichrichter 29 beispielsweise einen schematisch dargestellten Mikrocontroller 31 mit Energie versorgen, möglicherweise sogar mit einer Signalansteuerung, was induktiv möglich und dem Fachmann grundsätzlich bekannt ist. Vor allem aber kann eine LED 32 oder eine sonstige Anzeige bzw. Leuchtanzeige mit Energie versorgt werden bzw. zum Leuchten gebracht werden. Anstelle oder zusätzlich zu einer solchen LED können noch weitere oder andere Leuchtanzeigen vorgesehen sein.

In dem Gleichrichter 29 kann ein Brückengleichrichter vorgesehen, der zum Betrieb einer LED 32 eben notwendig ist. Bei anderen Leuchtanzeigen bzw. Leuchtmitteln oder Anzeigemitteln kann möglicherweise auf eine Gleichrichtung verzichtet werden. Alternativ und evtl. vorteilhafter kann eine Ein-Weg- oder Zwei-Weg-Gleichrichtung vorgesehen sein.

Je nach gewählter Frequenz kann ein Siebkondensator am Gleichrichter 29 vorgesehen sein oder aber auch entfallen. Gegebenenfalls sind weitere Bauteile zur Leistungsanpassung notwendig, was dem Fachmann jedoch bekannt ist. Die Helligkeit der LED 32 kann über Frequenz und Amplitude in der Primärwicklung 25 beeinflusst werden, also über die Ansteuerung 26.

Dadurch, dass die magnetisch leitende Drehachse 19 die Wicklungsebene der Sekundärwicklung 28 durchdringt, ist eine besonders gute magnetische Kopplung für den Transformator mit den beiden Wicklungen 25 und 28 möglich. So werden also Streuverluste verringert, was nicht nur eine effizientere Energieausnutzung bedeutet, sondern auch unerwünschte magnetische Feldlinien bzw. Einflüsse im Umfeld der Bedienvorrichtung 11 reduziert.

Alternativ zu einer Anordnung der Primärwicklung 25 in einem Gehäuse des Schaltgeräts 16 könnte sie auch vor diesem Gehäuse angeordnet sein, also sozusagen auf das Schaltgerät 16 aufgesetzt sein. Dann kann möglicherweise ein völlig übliches Schaltgerät 16 verwendet werden, und eine Vorsatzmontage stellt keinerlei Problem dar. Dann ist es auch möglich, einen Wechselrichter samt Elektronik zu integrieren, der mit Gleichspannung angesteuert werden kann, was eine einfache Ausführung ermöglicht.

In Fig. 2 ist eine alternative Ausgestaltung eines Drehknebels 21' dargestellt. Das Drehknebelgehäuse 22' ist grundsätzlich ähnlich ausgebildet, wobei die Sekundärwicklung 28' in den Drehknebel 21', der aus Kunststoff bestehen kann, fest und dauerhaft eingebaut bzw. eingespritzt ist. Über zwei Steckkontakte 30, die mit der Sekundärwicklung 28' verbunden sind, erfolgt ein elektrischer Anschluss an die Sekundärwicklung 28'. Hier ist ein eingesetztes Anzeigemodul 34 vorgesehen, welches einen Gleichrichter 29' und eine LED 32' aufweist. Dieses Anzeigemodul 34 ist in eine entsprechend korrespondierend ausgebildete Ausnehmung im Drehknebel 21' eingesetzt, beispielsweise nur eingedrückt und dann verrastet oder verklebt. Bei diesem Einsetzen wird die Kontaktierung über die Steckkontakte 30 hergestellt und somit das Anzeigemodul 34, insbesondere der Gleichrichter 29', mit der Sekundärwicklung 28' elektrisch verbunden. Bei dieser Ausführung eines Drehknebels 21' einer Bedienvorrichtung ist es also beispielsweise möglich, unterschiedliche Anzeigemodule 34 in dasselbe Drehknebelgehäuse 22' einzusetzen bzw. damit zu verbinden. So können einfach oder kompliziert aufgebaute und funktional ausgerüstete Drehknebel 21' hergestellt werden.

Die weitere Abwandlung eines Drehknebels 21" gemäß Fig. 3 zeichnet sich dadurch aus, dass in dem dortigen Drehknebelgehäuse 22" ein Einbaumodul 36 enthalten ist. Dieses Einbaumodul 36 enthält eine in ihm selbst angeordnete Sekundärwicklung 28", einen Gleitrichter 29" und eine LED 32" und ggfs. Weitere Teile, so dass die gesamte Funktionalität des Drehknebels 21" enthalten sein kann.

Wie zuvor für die Fig. 2 beschrieben, wird das Einbaumodul 36 in das Drehknebelgehäuse 22" eingesetzt und darin befestigt. Ein solches Einbaumodul 36 weist den Vorteil auf, dass, ähnlich wie für Fig. 2 beschrieben, mehrere Varianten auf einfache Art und Weise erzeugt werden können. Vor allem aber entfällt ein möglicherweise aufwändiges Anordnen oder Einspritzen der Sekundärwicklung in das Drehknebelgehäuse. Ebenso ist es dadurch möglich, ein Drehknebelgehäuse aus Metall wie Aluminium oder Edelstahl zu fertigen und dann ein im Wesentlichen aus Kunststoff bestehendes Einbaumodul oder Anzeigemodul darin einzusetzen.

## Patentansprüche

1. Bedienvorrichtung für ein Elektrogerät mit einer Bedieneinheit, die als Drehknebel ausgebildet ist und auf eine Drehachse aufgesetzt ist, die eine Abdeckung des Elektrogeräts durchdringt, wobei die Drehachse mit einem Schaltgerät verbunden ist zur Drehbedienung mittels des Drehknebels, wobei in dem Drehknebel elektrische Anzeigemittel angeordnet sind, **gekennzeichnet durch** eine induktive Energieversorgung der Anzeigemittel, wobei in dem Drehknebel eine Sekundärwicklung angeordnet ist, deren Wicklungsebene von der Drehachse und den magnetischen Feldlinien durchdrungen ist, die von einer Primärwicklung ausgehen, wobei die Drehachse zur Leitung der Feldlinien aus einem Material besteht, das die magnetischen Feldlinien gut leitet, wobei die Primärwicklung hinter der Abdeckung des Elektrogeräts bzw. der Bedienvorrichtung angeordnet ist und eine Wicklungsebene der Primärwicklung von der Drehachse durchdrungen ist.

2. Bedienvorrichtung nach Anspruch 1, **dadurch gekennzeichnet, dass** die Primärwicklung an oder in dem Schaltgerät bzw. einem Schaltgerätgehäuse angeordnet ist.

3. Bedienvorrichtung nach Anspruch 1 oder 2, **dadurch gekennzeichnet, dass** die Sekundärwicklung in dem Drehknebel eingelegt oder eingespritzt ist.

4. Bedienvorrichtung nach Anspruch 3, **dadurch gekennzeichnet, dass** die Sekundärwicklung in dem Drehknebel als Modul ausgebildet ist und in einer entsprechend ausgebildeten Aussparung im Drehknebel befestigt bzw. eingerastet ist.

5. Bedienvorrichtung nach einem der vorhergehenden Ansprüche, **dadurch gekennzeichnet, dass** die Anzeigemittel als LED ausgebildet sind.

6. Bedienvorrichtung nach einem der vorhergehenden Ansprüche, **dadurch gekennzeichnet, dass** eine Gleichrichtung an der Sekundärwicklung angeschlossen ist, vorzugsweise ein Brückengleichrichter, zum Betrieb von LED als Anzeigemittel.

7. Bedienvorrichtung nach einem der vorhergehenden Ansprüche, **dadurch gekennzeichnet, dass** sämtliche Bauteile in dem Drehknebel durch Vergießen befestigt sind.

8. Bedienvorrichtung nach einem der vorhergehenden Ansprüche, **dadurch gekennzeichnet, dass** die Teile der Energieversorgung für die Anzeigemittel im Drehknebel als Modul ausgebildet sind und in einer entsprechend ausgebildeten Aussparung in dem Drehknebel befestigt ist.

9. Bedienvorrichtung nach einem der vorhergehenden Ansprüche, **dadurch gekennzeichnet, dass** die Teile der Energieversorgung für die Anzeigemittel mit der Primärwicklung unter der Abdeckung als Modul ausgebildet sind und diese vorzugsweise an dem Schaltgerät befestigt ist.
